# EUROPÄISCHE PATENTSCHRIFT

(11) **EP 0 364 473 B1**
(45) Veröffentlichungstag und Bekanntmachung des Hinweises auf die Patenterteilung: **01.09.1993**
(21) Anmeldenummer: 88904959.9
(22) Anmeldetag: 25.05.1988
(51) Int. Cl.: H05K 13/00

(54) **HALTERUNG FÜR PLATTENFÖRMIGE GEGENSTÄNDE, INSBESONDERE ELEKTRISCHE LEITERPLATTEN**
HOLDING DEVICE FOR FLAT OBJECTS, IN PARTICULAR PRINTED CIRCUIT BOARDS
DISPOSITIF DE RETENUE D'OBJETS PLATS, EN PARTICULIER CARTES DE CIRCUITS IMPRIMES

(30) Priorität: 05.06.1987 DE 3718859
(43) Veröffentlichungstag der Anmeldung: 25.04.1990
(73) Patentinhaber: Gebr. Schmid GmbH & Co., D-72250 Freudenstadt (DE)
(72) Erfinder: SCHMID, Dieter, C., D-7290 Freudenstadt (DE)
(74) Vertreter: Patentanwälte Ruff, Beier, Schöndorf und Mütschele
(86) Internationale Anmeldenummer: EP8800464
(87) Internationale Veröffentlichungsnummer: WO8810062

(56) Entgegenhaltungen:
- DE-A- 3 516 853
- FR-A- 2 015 051
- FR-A- 2 439 734

## Beschreibung

Die Erfindung betrifft eine Halterung für plattenförmige Gegenstände, insbesondere elektrische Leiterplatten, die in der Halterung hochkant und mit gegenseitigem Abstand nebeneinander gehalten sind, mit einer Mehrzahl von Klemmbacken, die nebeneinander längs einer Führung frei verschieblich gelagert sind und durch Federmittel elastisch gegeneinander gespannt sind.

Elektrische Leiterplatten und andere plattenförmige Gegenstände werden zur Behandlung in Behandlungsvorrichtungen, beispielsweise Ätzmaschinen, und zum Transport in Halterungen gestellt, die nebeneinander Aufnahmeschlitze aufweisen, in die die plattenförmigen Gegenstände hochkant eingesetzt werden, so daß sie in gegenseitigem Abstand nebeneinander durch die Behandlungsvorrichtung oder zu einer anderen Handhabung transportiert werden können. Bei bekannten Vorrichtungen dieser Art ergibt sich die Schwierigkeit, daß die Breite der Aufnahmeschlitze der Breite der Gegenstände angepaßt sein muß, da anderenfalls die Gegenstände in einem zu breiten Aufnahmeschlitz umfallen oder in einen zu schmalen Aufnahmeschlitz nicht eingeführt werden können. Außerdem ergeben sich Schwierigkeiten bei plattenförmigen Gegenständen geringer Dicke, da diese in den Aufnahmeschlitzen nicht zuverlässig fixiert werden können. Beim Transport eines solchen Halters besteht weiterhin die Gefahr, daß die in die Aufnahmeschlitze eingesetzten plattenförmigen Gegenstände aus dem Halter herausfallen, da eine Festlegung innerhalb der Schlitze nicht möglich ist.

Aus der FR-A 2 439 734 ist eine Halterung für elektrische Leiterplatten bekannt, bei der diese in Schlitze von Haltern eingeschoben werden können. Diese Schlitze haben eine feste Breite und sind daher nur für Leiterplatten einer bestimmten Dimensionierung geeignet. Wenn die Leiterplatten in diesen Schlitzen festgehalten werden sollen, müssen sie in diesen im Klemmsitz sitzen. Das bedeutet bei der Bestückung, daß die Leiterplatten gegen starke Reibungskräfte in die Schlitze eingeschoben und wieder aus ihnen herausgezogen werden müssen. Dabei können die Leiterplatten beschädigt werden. Außerdem ergibt sich dadurch ein erhöhter Verschleiß bei der Halterung selbst.

Es ist Aufgabe der Erfindung, eine gattungsgemäße Halterung derart zu verbessern, daß sie einerseits für plattenförmige Gegenstände unterschiedlicher Dicke verwendet werden kann, daß sie andererseits die eingesetzten plattenförmigen Gegenstände nach dem Einlegen zuverlässig fixiert und daß es möglich ist, benachbarte Klemmbacken zum Einlegen und Herausnehmen der Leiterplatten gegebenenfalls auch automatisch voneinander zu entfernen.

Diese Aufgabe wird bei einer Halterung der eingangs beschriebenen Art erfindungsgemäß dadurch gekennzeichnet, daß die Klemmbacken an ihren Seiten-Enden Abschrägungen aufweisen, so daß zwischen aneinanderliegenden Klemmbacken eine Ausnehmung mit seitlich nach außen hin divergierenden Seitenflächen entsteht, und daß an den Seitenflächen anliegende Spreizelemente bildende Keile von außen in die Ausnehmung einschiebbar sind. Es ist auf diese Weise auch unter Verwendung einer Maschinenbestückungseinrichtung möglich, benachbarte Klemmbacken voneinander zu entfernen, so daß ein Gegenstand von Hand oder maschinell in den entstehenden Spalt eingesetzt werden kann. Die Abschrägungen können an beiden aneinander anliegenden Klemmbacken vorgesehen sein oder nur an einer, wesentlich ist lediglich, daß ein Zwischenraum zwischen den benachbarten Klemmbacken entsteht, in den das keilförmige Spreizelement eingeschoben werden kann, so daß die Klemmbacken auseinandergezwungen werden.

Die plattenförmigen Gegenstände können in den Halter genau vertikal eingesetzt werden, die Schlitze können aber auch gegenüber der Halterebene geneigt sein, so daß die plattenförmigen Gegenstände parallel zueinander, aber schräg gegenüber der Halterungsebene in die Halterung eingesetzt sind. Sowohl die schräge als auch die senkrechte Einsteckposition wird im folgenden mit dem Ausdruck "hochkant" erfaßt.

Bei einer ersten bevorzugten Ausführungsform ist vorgesehen, daß die Führung mindestens eine Stange ist, die die Klemmbacken durchdringt. Insbesondere kann vorgesehen sein, daß die Stangen die Klemmbacken in deren unterer Hälfte durchdringen. Diese Führungsstangen übernehmen bei einer Halterung dieser Art eine Doppelfunktion, da sie einerseits die Klemmbacken relativ zueinander frei verschieblich führen und andererseits die Einführspalte zwischen benachbarten Klemmbacken an der Unterseite begrenzen, so daß die Einschubtiefe der Gegenstände dadurch begrenzt wird, daß die Gegenstände mit ihrer Unterkante an der Führungsstange anliegen.

Bei einer weiteren bevorzugten Ausführungsform können die Klemmbacken mit einem Stützteil die jeweils benachbarte Klemmbacke untergreifen. Dieses Stützteil dient als untere Begrenzung des Einschubspaltes, an ihm wird der in den Spalt zwischen zwei Klemmbacken eingesetzte plattenförmige Gegenstand angelegt, so daß eine definierte Aufnahmeposition gewährleistet ist.

Bei einer anderen Ausführungsform besteht die Führung aus zwei paarweise die Enden der Klemmbacken umgreifenden Profilleisten, die zwischen sich einen Einsteckbereich für die plattenförmigen Gegenstände freilassen.

Die Federmittel können durch eine die Klemmbacken durchsetzende und an den beiden äußersten Klemmbacken befestigte Zugfeder oder Gummischnur gebildet sein. Es ist auch möglich, daß der Halter in einem Rahmen gehalten ist, an dem sich Druckfedern abstützen, die an den äußeren Klemmbacken anliegen.

Bei einer bevorzugten Ausführungsform ist eine Vielzahl von Federn vorgesehen, die jeweils nur an zwei Klemmbacken angreifen. Es kann sich dabei um Zugfedern handeln, die jeweils zwei Klemmbacken gegeneinander spannen, oder um Druckfedern, die benachbarte Klemmbacken auseinanderdrücken. Bei der letzteren Ausgestaltung wird dann noch eine starke Feder verwendet, die die Klemmbacken gegen die Kraft der einzelnen Druckfedern insgesamt gegeneinanderdrücken.

Diese Verwendung einzelner Federn hat den Vorteil, daß die Halterung insgesamt flexibler bleibt, da keine durchgehenden Federn verwendet werden. Dies kann insbesondere dann von Vorteil sein, wenn die Halterung an einer maschinenfesten Führung geführt ist, die aus der Vorschubebene herausgebogen ist, beispielsweise in einem Belade- oder Entladebereich.

Die Halterung kann als selbständig transportierbare Baueinheit ausgebildet sein, es ist aber auch möglich, eine solche Halterung in einer maschinenfesten Führung vorzusehen, längs welcher die Halterung bei der Bearbeitung der Gegenstände verschoben wird.

Die nachfolgende Beschreibung bevorzugter Ausführungsformen dient im Zusammenhang mit der Zeichnung der näheren Erläuterung. Es zeigen:
- Figur 1:: eine schematische, perspektivische Ansicht einer ersten Ausführungsform einer Halterung mit Klemmbacken, die von einer Führungsstange durchdrungen sind;
- Figur 2:: eine Längsschnittansicht einer weiteren bevorzugten Ausführungsform einer Halterung mit benachbarte Klemmbacken untergreifenden Stützteilen;
- Figur 3:: eine Seitenansicht einer längs einer gebogenen Führung verschiebbaren Halterung;
- Figur 4:: eine Schnittansicht längs Linie 4-4 in Figur 3;
- Figur 5:: eine Draufsicht auf eine in einem Rahmen angeordnete Halterung;
- Figur 6:: eine Teildraufsicht auf eine Halterung mit seitlich angreifenden Spreizelementen;
- Figur 7:: eine schematische Draufsicht auf eine Halterung mit einzelnen Druckfedern zwischen benachbarten Klemmbacken;
- Figur 8:: eine schematische Seitenansicht einer Halterung mit einzelnen Zugfedern zwischen benachbarten Klemmbacken und
- Figur 9:: eine schematische Seitenansicht einer Behandlungsvorrichtung, in der Halterungen mit von Federn gegeneinander gedrückten Klemmbacken verwendet werden.

Die nachstehend beschriebenen Halterungen sind zur Halterung beliebiger plattenförmiger Gegenstände geeignet, im folgenden werden beispielhaft elektrische Leiterplatten genannt, die zur Aufnahme von elektrischen Schaltelementen dienen und zur Vorbereitung einer vielfältigen Behandlung unterzogen werden, bei welcher die Leiterplatten in Flüssigkeiten chemisch und physikalisch bearbeitet werden. Zu diesem Zwecke müssen die Leiterplatten für die Behandlungsflüssigkeit frei zugänglich gehaltert werden und nach der Behandlung von einer Behandlungsstation in eine andere Behandlungsstation zur Trocknung etc. transportiert werden. Zu diesem Zweck dienen die im folgenden beschriebenen Halterungen.

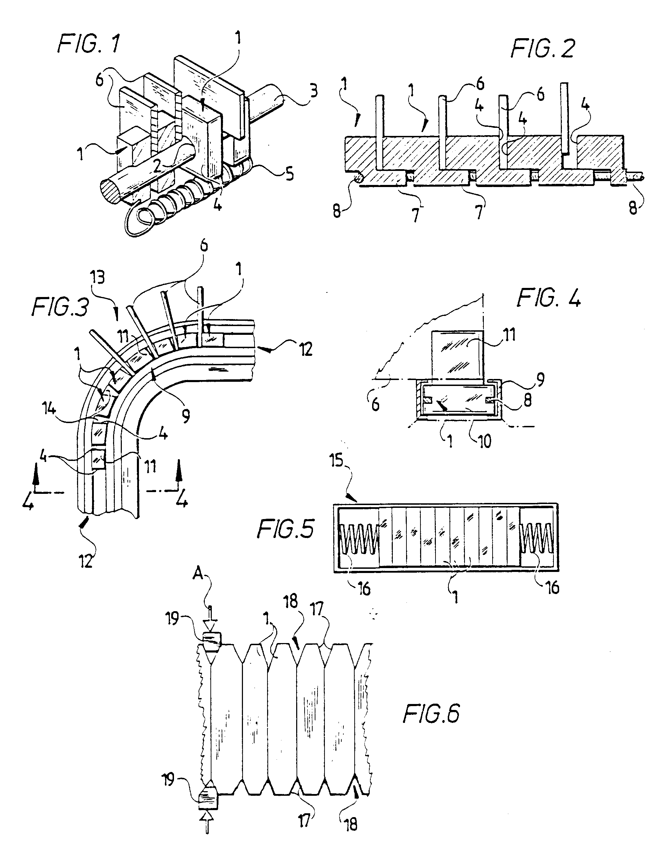

Eine solche Halterung besteht bei einem ersten, in Figur 1 dargestellten Ausführungsbeispiel aus einer Mehrzahl von platten- oder leistenförmigen Klemmbacken 1, die eine Bohrung 2 aufweisen. Durch die fluchtend miteinander ausgerichteten Bohrungen 2 aller Klemmbacken 1 ist eine Führungsstange 3 hindurchgeschoben, so daß alle Klemmbacken senkrecht zu ihrer Klemmfläche 4 längs der Führungsstange 3 frei verschieblich sind. An den beiden äußeren Klemmbacken sind die Enden einer Zugfeder 5 befestigt, die in Figur 1 nur schematisch unterhalb der Klemmbacken 1 dargestellt ist. Obwohl die Zugfeder in dieser Weise unterhalb der Klemmbacken angeordnet sein kann, ist es vorteilhaft, diese durch in der Zeichnung nicht dargestellte weitere Bohrungen in den Klemmbacken 1 hindurchtreten zu lassen, so daß sich die Zugfeder innerhalb des Umrisses der Klemmbacken befindet. In der Zeichnung ist ein Ausführungsbeispiel mit nur einer Führungsstange 3 dargestellt; selbstverständlich ist es auch möglich, statt der einen Führungsstange beispielsweise zwei paarweise nebeneinander angeordnete Führungsstangen zu verwenden, die gemeinsam jede Klemmbacke durchdringen, so daß die Klemmbacken längs dieser Führung sicher geführt sind. Die Führungsstange 3 kann - wie in Figur 1 dargestellt - einen kreisförmigen Querschnitt haben, es ist auch die Verwendung von Führungsstangen möglich, die einen vom Kreis abweichenden Querschnitt aufweisen und durch komplementäre Öffnungen in den Klemmbacken hindurchtreten, so daß die Klemmbacken auch bei Verwendung von nur einer Führungsstange gegen Verdrehung um die Führungsachse gesichert sind.

Durch die Zugfeder 5 werden die Klemmbacken 1 mit ihren Klemmflächen 4 elastisch gegeneinander gespannt. Entfernt man zwei benachbarte Klemmbacken gegen die Kraft der Zugfeder 5 voneinander, bildet sich zwischen diesen ein Spalt aus, in den hochkant ein plattenförmiger Gegenstand 6 eingeführt werden kann, bis dessen Unterkante an der die Klemmbacken 1 durchsetzenden Führungsstange 3 anliegt. Läßt man die Klemmbacken 1 daraufhin wieder los, werden sie durch die Zugfeder 5 gegeneinander gespannt, wobei die Klemmflächen 4 der beiden Klemmbacken 1 den unteren Randbereich des Gegenstandes 6 zwischen sich einklemmen und im Reibschluß fixieren. Die Einschubtiefe wird dabei durch den Anschlag des Gegenstandes 6 an der Führungsstange 3 definiert. In dieser Weise kann zwischen jeweils zwei Klemmbacken 1 je ein Gegenstand 6 eingeführt werden, wobei die Gegenstände unterschiedliche Dicke haben können. Trotzdem werden alle Gegenstände parallel im Abstand zueinander in der Halterung sicher fixiert, wobei die Gegenstände nach Beendigung der Behandlung in einfacher Weise unter Überwindung der Reibungskräfte oder nach Spreizung der Klemmbacken aus der Halterung herausgezogen werden können.

Die gesamte beschriebene Halterung kann eine Baueinheit bilden, so daß die mit Gegenständen bestückte Halterung nach Bedarf von einer Behandlungsstation zu einer anderen transferiert werden kann. Es wäre auch möglich, die Halterung als Einheit längs einer maschinenfesten Führung zu bewegen, wobei entsprechende Antriebseinrichtungen vorgesehen werden müssen, die die durch die Zugfeder zusammengespannten Klemmbacken als Einheit längs der Führungsstange 3 verschiebt.

Die in Figur 2 dargestellte Halterung ist ähnlich aufgebaut, einander entsprechende Teile tragen daher dieselben Bezugszeichen.

Die Klemmbacken sind bei diesem Ausführungsbeispiel an ihrer Unterseite mit einem seitlich versetzten Stützteil 7 versehen, welches die jeweils benachbarte Klemmbacke 1 untergreift. Wenn die Klemmbacken 1 voneinander entfernt werden, ergibt sich dadurch zwischen benachbarten Klemmbacken 1 ein Spalt zur Aufnahme der Gegenstände 6, der an der Unterseite durch das Stützteil 7 begrenzt wird. In diesem Ausführungsbeispiel wird also als unterer Anschlag nicht die Führungsstange 3, sondern dieses separate Stützteil 7 verwendet.

Die Klemmbacken 1 werden bei dem Ausführungsbeispiel der Figur 2 nicht durch eine Schraubenfeder gegeneinander gespannt, sondern durch eine elastische Schnur 8 aus Gummi oder einem anderen elastischen Kunststoff, die um die Stützteile 7 der aneinanderliegenden Klemmbacken als Ring herumgelegt ist und dadurch die Klemmbacken 1 insgesamt gegeneinander spannt.

Bei dem Ausführungsbeispiel der Figur 3 werden die Klemmbacken 1 zwischen zwei paarweise angeordnete, die Klemmbacken 1 an der Außenseite umgebende Profilleisten 9 geführt. Bei dem in den Figuren 3 und 4 dargestellten Ausführungsbeispiel weisen die Klemmbacken 1 dazu einen innerhalb der Profilleisten 9 geführten Fuß 10 auf, der mit einem zwischen den Profilleisten 9 nach oben überstehenden Klemmteil 11 versehen ist. Durch eine die Füße 10 umgebende Ringschnur 8 aus Gummi oder einem anderen elastischen Material sind die Klemmbacken 1 in ähnlicher Weise wie beim Ausführungsbeispiel der Figur 2 elastisch zusammengespannt.

Die Profilleisten 9 können Teil einer Vorrichtung sein und nebeneinander ebene Bereiche 12 und mindestens einen Bereich 13 aufweisen, in dem sie aus der Ebene des Bereiches 12 abgebogen sind, beispielsweise unter einem Winkel von 90°, wie dies in Figur 3 dargestellt ist. Werden die durch die Gummischnur 8 zusammengehaltenen Klemmbacken 1 längs der Führung verschoben, bilden sich zwischen benachbarten Klemmbacken 1 beim Durchlaufen des gebogenen Bereiches 13 keilförmige Spalte 14 aus, in die Gegenstände 6 eingesetzt werden können. Beim weiteren Verschieben nimmt die Halterung die eingesetzten Gegenstände mit, und beim Erreichen des ebenen Bereiches 12 werden die benachbarten Klemmbacken wieder über ihre gesamte Höhe durch die Gummischnur 8 gegeneinander gespannt, so daß beim Verlassen des gebogenen Bereiches 13 der eingesetzte Gegenstand fest zwischen benachbarten Klemmbacken eingespannt wird. Eine solche gebogene Führung schafft somit einen Bereich, in dem die Gegenstände ohne weiteres zwischen benachbarten Klemmbacken 1 eingesetzt werden können, ohne daß es dazu notwendig wäre, die Klemmbacken zu diesem Zweck eigens auseinanderzudrücken.

Bei dem in den Figuren 3 und 4 dargestellten Ausführungsbeispiel weisen die Klemmbacken einen Fuß 10 und einen Klemmteil 11 auf. Es können zwei Halterungen gemeinsam verwendet werden, die jeweils an einer Ecke eines plattenförmigen Gegenstandes angreifen, so daß der größte Teil des plattenförmigen Gegenstandes nicht von den Klemmbacken berührt wird und daher für eine Behandlung freiliegt. Bei einem anderen, in der Zeichnung nicht dargestellten Ausführungsbeispiel können sich die Halterungen auch über die gesamte Breite der plattenförmigen Gegenstände erstrecken, wobei dann der untere Randbereich vollständig abgedeckt wird. Um den Randbereich niedrig zu halten, kann vorgesehen werden, daß die Klemmbacken leistenförmig ausgebildet und insgesamt breiter sind, als die aufzunehmenden plattenförmigen Gegenstände. Diese Klemmbacken werden dann durch Profilleisten 9 geführt, deren gegenseitiger Abstand größer ist als die Breite der einzusetzenden Gegenstände, so daß die Gegenstände zwischen einander gegenüberliegenden Profilleisten zwischen die Klemmbacken eingeführt werden können.

In Figur 5 ist eine Halterung mit Klemmbacken 1 dargestellt, die in einem äußeren Rahmen 15 geführt sind, an dem sich auf gegenüberliegenden Seiten der Halterung jeweils eine Druckfeder 16 abstützt. Die beiden Druckfedern liegen an den äußeren Klemmbacken der Halterung an und drücken dadurch alle Klemmbacken gegeneinander. Eine solche Halterung hat einen sehr stabilen Aufbau und läßt sich als Baueinheit leicht transportieren.

Die in Figur 6 dargestllten Klemmbacken eines weiteren Ausführungsbeispiels einer Halterung weisen an ihren außen gelegenen Enden Abschrägungen 17 auf, die so angeordnet sind, daß zwischen zwei aneinanderliegenden Klemmbacken 1 keilförmige Ausnehmungen 18 entstehen. In diese Ausnehmungen 18 können ebenfalls keilförmig ausgebildete Spreizelemente 19 in Richtung der Pfeile A in Figur 6, also quer zur Verschieberichtung der Klemmbacken, eingeschoben werden, so daß beim Einschieben benachbarte Klemmbacken auseinandergedrückt werden. Dadurch bildet sich zwischen benachbarten Klemmbacken ein Spalt zur Einführung eines Gegenstandes. Diese Spreizelemente 19 können von Hand eingeführt werden, vorzugsweise werden sie jedoch Teil einer automatischen Beschickungsvorrichtung sein, welche mittels der Spreizelemente 19 zwei benachbarte Klemmbacken auseinanderschiebt und dann einen zu behandelnden Gegenstand zwischen die Klemmbacken einsetzt. Nach dem Herausziehen der Spreizelemente 19 liegen die Klemmbacken dann im Reibschluß an dem zwischen ihnen gehaltenen Gegenstand an.

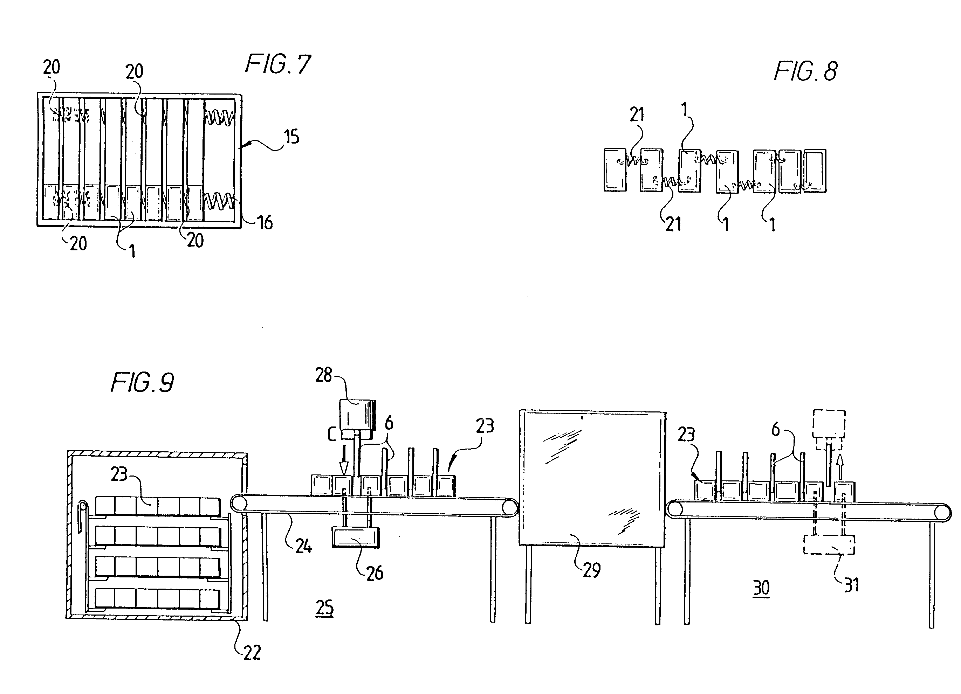

Bei dem Ausführungsbeispiel der in Figur 7 dargestellten Halterung ist diese ähnlich ausgebildet wie die Halterung der Figur 5, jedoch sind zwischen jeweils benachbarten Klemmbacken 1 zusätzlich Druckfedern 20 angeordnet, die sich jeweils an benachbarten Klemmbacken 1 abstützen und so dimensioniert sind, daß normalerweise die Druckfedern 16 die Klemmbacken gegen die Kraft der Druckfeder 20 fest gegeneinander drücken. Wenn in einer Spreizvorrichtung die äußere Klemmbacke gegen die Kraft der Druckfeder 16 verschoben wird, führt dies dazu, daß in der gesamten Halterung gleichmäßig breite Spalte 14 ausgebildet werden, das heißt mit der Spreizvorrichtung kann aufgrund der Verwendung einer größeren Anzahl von Druckfedern 20 zwischen allen Klemmbacken gleichzeitig dieser Spalt geöffnet werden. Dadurch können mit einer Spreizvorrichtung mehrere plattenförmige Gegenstände gleichzeitig in die Halterung eingesetzt werden.

Bei der in Figur 8 dargestellten Ausführungsform einer Halterung sind jeweils zwischen benachbarten Klemmbacken 1 einzelne Zugfedern 21 vorgesehen, die jeweils an benachbarten Klemmbacken angreifen und diese gegeneinander spannen. Durch die große Anzahl der Zugfedern 21 werden alle Klemmbacken einer Halterung gegeneinander gespannt, trotzdem wird die Flexibilität der Halterung erhalten, die verloren gehen kann, wenn eine einzige Zugfeder sich über die gesamte Länge einer Halterung erstreckt, wie dies beim Ausführungsbeispiel der Figur 1 angedeutet ist. Eine solche Ausgestaltung kann insbesondere dann von Vorteil sein, wenn diese Halterung in einer Führung 9 entsprechend dem Ausführungsbeispiel der Figur 3 verwendet wird.

Die beschriebenen Halterungen zeichnen sich durch einen besonders einfachen und stabilen Aufbau aus und ermöglichen es, zu haltende plattenförmige Gegenstände in einfacher Weise einzusetzen und stabil zu haltern, so daß die Halterung als separates Bauteil oder als Teil einer Bearbeitungs- oder Behandlungsvorrichtung verwendet werden kann, um eine Vielzahl von plattenförmigen Gegenständen zu transportieren, zu bearbeiten oder zu behandeln. Speziell bei der Verwendung in mit Chemikalien arbeitenden Behandlungsstationen für elektrische Leiterplatten ist es vorteilhaft, wenn die Einzelteile aus chemikalienbeständigen Materialien hergestellt werden, so daß die Halterungen zusammen mit den darin gehaltenen Gegenständen in Bäder eingetaucht oder mit Chemikalen besprüht werden können.

In Figur 9 ist schematisch eine Vorrichtung dargestellt, die der Behandlung von plattenförmigen Gegenständen dient und in der die vorstehend beschriebenen Halterungen verwendet werden können. Diese Vorrichtung umfaßt ein Magazin 22, in dem eine größere Anzahl von leeren Halterungen 23 der oben beschriebenen Art aufbewahrt wird. Das Magazin 22 gibt bei Bedarf eine leere Halterung auf eine Vorschubstrecke 24 ab, welche die Halterung 23 zunächst in eine Beladestation 25 transportiert. In dieser befindet sich eine Spreizvorrichtung 26, die beispielsweise in der an Hand der Figur 6 erörterten Art benachbarte Klemmbacken gegen die Federkräfte der die Klemmbacken zusammendrückenden Federn auseinander führt und somit zwischen diesen einen Einfuhrspalt 14 ausbildet. Eine in der Beladestation 25 angeordnete Ladevorrichtung 28 führt einen plattenförmigen Gegenstand 6 heran und setzt diesen in Richtung des Pfeiles C in den geöffneten Spalt 14 ein. Nach dem Einsetzen gibt die Spreizvorrichtung 26 die Klemmbacken wieder frei, so daß diese unter der Kraft der sie gegeneinanderspannenden Feder den eingesetzten Gegenstand beidseitig klemmend zwischen sich halten.

Das Aufspreizen benachbarten Klemmbacken kann schrittweise erfolgen, das heißt es wird jeweils ein Klemmbackenpaar aufgespreizt, es ist aber auch möglich, die Spreizvorrichtung so auszugestalten, daß alle Klemmbacken gleichzeitig aufgespreizt werden, so daß eine größere Anzahl von Gegenständen gleichzeitig in die geöffneten Spalte eingesetzt werden können. Das Einsetzen der Gegenstände kann von Hand erfolgen, es ist aber mit der in Figur 9 dargestellten Vorrichtung möglich, das Einsetzen vollautomatisch durchzuführen, wenn die Spreizvorrichtung 26 und die Ladevorrichtung 28 in ihrem Arbeitsablauf synchronisiert sind.

Die gefüllte Halterung 23 wird dann in eine Bearbeitungsstation 29 eingeführt. Diese kann unmittelbar in die Vorschubstrecke 24 eingesetzt sein, wie dies in Figur 9 dargestellt ist, es ist aber auch möglich, daß die gefüllte Halterung zu einer separat angeordneten Behandlungsvorrichtung transportiert wird und in diese eingesetzt wird. Es zeigt sich dabei, daß die Verwendung von Halterungen der beschriebenen Art einen sehr flexiblen Arbeitsablauf gestattet, da die Halterungen auch als separate Einheiten transportierbar sind, wobei die eingesetzten plattenförmigen Gegenstände ihre Position sicher beibehalten.

An die Bearbeitungsstation 29 anschließend ist eine Entladestation 30 vorgesehen, in der die behandelten Gegenstände entweder einfach unter Überwindung des Reibschlusses aus der Halterung 23 nach oben herausgezogen werden oder in der die Entnahme der behandelten Gegenstände nach erneutem Aufspreizen der Halterung erfolgt. Zu diesem Zweck kann auch in der Entladestation 30 eine Spreizvorrichtung 31 vorgesehen sein.

## Patentansprüche

1. Halterung für plattenförmige Gegenstände, insbesondere elektrische Leiterplatten, die in der Halterung hochkant und mit gegenseitigem Abstand nebeneinander gehalten sind, mit einer Mehrzahl von Klemmbacken, die nebeneinander längs einer Führung frei verschieblich gelagert sind und durch Federmittel elastisch gegeneinander gespannt sind,
dadurch gekennzeichnet, daß die Klemmbacken (1) an ihren Seiten-Enden Abschrägungen aufweisen, so daß zwischen aneinanderliegenden Klemmbacken (1) eine Ausnehmung (18) mit seitlich nach außen hin divergierenden Seitenflächen entsteht, und daß an den Seitenflächen anliegende und Spreizelemente (19) bildende Keile von außen her in die Ausnehmung (18) einschiebbar sind.

2. Halterung nach Anspruch 1, dadurch gekennzeichnet, daß die Führung mindestens eine Stange (3) ist, die die Klemmbacken (1) durchdringt.

3. Halterung nach Anspruch 2, dadurch gekennzeichnet, daß die Stangen (3) die Klemmbacken (1) in deren unterer Hälfte durchdringen.

4. Halterung nach Anspruch 1 oder 2, dadurch gekennzeichnet, daß die Klemmbacken (1) mit einem Stützteil (7) die jeweils benachbarte Klemmbacke (1) untergreifen.

5. Halterung nach einem Ansprüche 1 bis 4, dadurch gekennzeichnet, daß die Führung aus zwei paarweise die Enden der Klemmbacken (1) umgreifenden Profilleisten (9) besteht, die zwischen sich einen Einsteckbereich für die plattenförmigen Gegenstände (6) freilassen.

6. Halterung nach einem der voranstehenden Ansprüche, dadurch gekennzeichnet, daß die Federmittel durch eine die Klemmbacken (1) durchsetzende und an den beiden äußeren Klemmbacken befestigte Zugfeder (5) oder Gummischnur (8) gebildet sind.

7. Halterung nach einem der Ansprüche 1 bis 5, dadurch gekennzeichnet, daß die Klemmbacken (1) in einem Rahmen (15) geführt sind, an dem sich Druckfedern (16) abstützen, die an den äußeren Klemmbacken (1) anliegen.

8. Halterung nach einem der Ansprüche 1 bis 5, dadurch gekennzeichnet, daß eine Vielzahl von Federn (20; 21) vorgesehen ist, die jeweils nur an zwei Klemmbacken (1) angreifen.

## Claims

1. Holding device for flat objects, in particular printed circuit boards, which are held in on-end, juxtaposed and reciprocately spaced manner in the holding device, having a plurality of clamping jaws, which are freely displaceably mounted in juxtaposed manner along a guide and which are elastically tensioned against one another by spring means, characterized in that the clamping jaws (1) have on their side ends bevels, so that between engaging clamping jaws (1) is formed a recess (18) with laterally outwardly diverging side faces and that wedges engaging on the side faces and forming expanding elements (19) can be inserted from the outside into the recess (18).

2. Holding device according to claim 1, characterized in that the guide is at least one rod (3), which penetrates the clamping jaws (1).

3. Holding device according to claim 2, characterized in that the rods (3) penetrate the lower half of the clamping jaws (1).

4. Holding device according to claim 1 or 2, characterized in that the clamping jaws (1) engage by a support part (7) the in each case adjacent clamping jaw (1).

5. Holding device according to one of the claims 1 to 4, characterized in that the guide comprises two profile strips (9) embracing pairwise the ends of the clamping jaws (1) and leaving between them a plug-in area for the flat objects (6).

6. Holding device according to one of the preceding claims, characterized in that the spring means are formed by a tension spring (5) or elastic cord (8) fixed to the two outer clamping jaws (1) and traversing the latter.

7. Holding device according to one of the claims 1 to 5, characterized in that the clamping jaws (1) are guided in a frame (15) on which are supported compression springs (16), which engage on the outer clamping jaws (1).

8. Holding device according to one of the claims 1 to 5, characterized in that there is a plurality of springs (20,21), which in each case only act on two clamping jaws (1).

## Revendications

1. Dispositif de retenue d'objets plats, en particulier cartes de circuits imprimés, qui sont disposés dans le dispositif de retenue côte à côte, verticalement et à une certaine distance l'un par rapport à l'autre, ledit dispositif comportant une pluralité de mâchoires de serrage placées côte à côte, de manière librement coulissable le long d'un guidage et serrées élastiquement les unes contre les autres au moyen de ressorts, caractérisé en ce que les mâchoires de serrage (1) présentent, sur leurs extrémités latérales, des parties obliques de telle sorte que, entre deux mâchoires (1) juxtaposées, se forme un évidement (18) à face latérale divergente latéralement vers l'extérieur et qu'il est possible d'introduire dans cet évidement (18), de l'extérieur, des cales venant s'appliquer sur ses faces latérales et formant des éléments d'écartement (19).

2. Dispositif de retenue selon la revendication 1, caractérisé en ce que le guidage est au moins une barre (3) qui pénètre à travers les mâchoires de serrage (1).

3. Dispositif de retenue selon la revendication 2, caractérisé en ce que les barres (3) pénètrent à travers les mâchoires de serrage (1) dans leur moitié inférieure.

4. Dispositif de retenue selon la revendication 1 ou 2, caractérisé en ce que chaque mâchoire de serrage (1) saisit, par en dessous, la mâchoire de serrage (1) respectivement adjacente, au moyen d'un élément de renfort (7).

5. Dispositif de retenue selon l'une des revendications 1 à 4, caractérisé en ce que le guidage est constitué de deux tringles profilées (9) entourant par paires les extrémités des mâchoires de serrage (1), une zone d'insertion des objets en forme de cartes (6) étant laissée libre entre les tringles profilées (9).

6. Dispositif de retenue selon l'une des revendications précédentes, caractérisé en ce que les ressorts sont constitués par un ressort de traction (5) ou une cordelette en caoutchouc (8) traversant les mâchoires de serrage (1) et fixé sur les deux mâchoires de serrage extérieures.

7. Dispositif de retenue selon l'une des revendications 1 à 5, caractérisé en ce que les mâchoires de serrage (1) sont guidées à l'intérieur d'un cadre (15) sur lequel s'appuient les ressorts de compression (16) qui viennent s'appliquer sur les mâchoires de serrage extérieures (1).

8. Dispositif de retenue selon l'une des revendications 1 à 5, caractérisé en ce qu'il comprend une pluralité de ressorts (20 ; 21) dont chacun agit seulement sur deux mâchoires de serrage (1).
